# EUROPEAN PATENT SPECIFICATION

(11) **EP 4 503 879 B1**
(45) Date of publication and mention of the grant of the patent: **04.03.2026**
(21) Application number: 24192399.4
(22) Date of filing: 01.08.2024
(51) Int. Cl.: H05K 7/14

(54) **CONTROLLER CABINET AND BREAKOUT ASSEMBLY BOARD**
SCHALTSCHRANK UND BREAKOUT-MONTAGEPLATTE
ARMOIRE DE COMMANDE ET CARTE D'ENSEMBLE DE BRANCHEMENT

(30) Priority: 01.08.2023 SE 2350938
(43) Date of publication of application: 05.02.2025
(73) Proprietor: Instec AB, 753 31 Uppsala (SE)
(72) Inventor: NORELL, Stefan, 753 28 Uppsala (SE)
(74) Representative: Ström & Gulliksson AB

(56) References cited:
- US-B1- 10 352 972
- US-B2- 10 152 032

## Description

### TECHNICAL FIELD

The present invention relates to building management and more precisely to a control cabinet for building automation.

### BACKGROUND

Building management, also known as facility management or property management, is the process of overseeing and optimizing the various aspects of a building's operations and maintenance to ensure its efficient, safe, and sustainable functioning. It involves the coordination of multiple disciplines and services to create a conducive environment for occupants and visitors while preserving the value and integrity of the property. For example, building management may include control and monitoring of building utilities such as heating, hot water, ventilation, cooling, humidification, dehumidification, and the like.

As more and more facilities of a building are becoming connected and controllable, building automation and more advanced building control is becoming increasingly important. However, buildings are generally different and there is no universal solution for controlling all buildings. Control of each building is generally customized and requires specialized hardware, configurations, and installations that are time consuming and expensive to provide. For example, a controller cabinet for a building is normally constructed from scratch by deciding which components are to be connected and which signals are required. Such controller cabinets are assembled and connected electrically before delivery to the customer, which lacks flexibility of operation.

US 10,152,032 B2 discloses a system and method for controlling and monitoring environmental conditions in a building using an integrated rack. The system may include at least one rack including a plurality of slidable field panels mounted in a housing. The slidable field panels may be in side-by-side relation in a horizontal direction and may be configured to independently slide at least partially out of a front side opening of the housing via a plurality of slides. The slidable field panels may include a plurality of components mounted to vertical walls thereof, including transformers and building control modules. The rack may also include a terminal panel including a plurality of connection terminals facing a back side opening of the housing. The connection terminals may be respectively wired to respective terminals of the transformers and building control. The system may include at least one data processing system including at least one processor configured to communicate with the building control modules to cause the rack when a heating, ventilating, and air conditioning (HVAC) system is wired to at least some of the connection terminals, to monitor and control the HVAC.

### SUMMARY

An object of the present invention is to provide a new type of controller cabinet which is improved over prior art and which eliminates or at least mitigates the drawbacks discussed above. More specifically, one object of the invention is to provide a configurable controller cabinet that is comparably quick to pre-fabricate, easy to specify and order, and quick to install, which reduces sources of errors, increases quality and reduces costs of pre-manufacturing and installation. In particular, a configurable controller cabinet is provided that can be connected to various different programmable controllers and regulators for different functions/systems of a building. These objects are achieved by the technique set forth in the appended independent claims with preferred embodiments defined in the dependent claims related thereto.

In first aspect, a breakout assembly board is presented. The breakout assembly board comprises a plurality of connection blocks configured to provide a connection to one or more functions of a building, a plurality of port connectors configured to be connected to a plurality of ports of a controller device, and routing adapted to connect the plurality of port connectors to one or more of the connection blocks such that the controller device is operatively connected to the one or more functions of the building.

In a second aspect, a configurable controller cabinet for management of a building having one or more functions is presented. The controller cabinet comprises a breakout assembly board of the first aspect. The controller cabinet further comprises a controller device configured to control the one or more functions of the building. The controller device is provided with a plurality of ports.

The configurable controller cabinet reduces time required for both pre-fabrication of the controller cabinet and installation at the building. The configurable controller cabinet is quick to pre-fabricate, easy to specify and order, and quick to install, which reduces sources of errors, increases quality and reduces costs of pre-manufacturing and installation. By implementing the breakout assembly board comprising a plurality of connection blocks and a plurality of port connectors, the configurable controller cabinet provides an interface for a standardized installation process and decreases a risk of mistakes during pre-manufacturing and installation.

In some variants, a number of connection blocks of the breakout assembly board is greater than a number of ports of the controller device. This is beneficial as e.g. power connections, common references and common control signals are utilized by several external devices and by having more than one of such connections reduces time during both pre-fabrication and installation as no internal splitters are required.

In some variants, the breakout assembly board comprises a plurality of function blocks, wherein each function block comprises two or more connection blocks. This is beneficial as incoming exterior cabling may be directly routed and marked to the associated function block reducing installation time and a risk of mistakes during installation at the building.

In some variants, the breakout assembly board is configured to connect at least one respective connection block of two or more function blocks to a common reference of the controller device. This is beneficial as e.g. ground connections, common control voltages and/or common power feeds are utilized by several external devices and by having more than one of such connections reduces time during both pre-fabrication and installation as no internal splitters are required.

In some variants, the breakout assembly board is configured to connect at least one respective connection block of two or more function blocks to a power supply voltage of the controller device. This is beneficial as e.g. ground connections, common control voltages and/or common power feeds are utilized by several external devices and by having more than one of such connections reduces time during both pre-fabrication and installation as no internal splitters are required.

In some variants, the function blocks are one or more of an input function block, an output function block, a power function block, a sensor function block and/or a general purpose input/output, GPIO, function block.

In some variants, the controller cabinet further comprises a mounting rail, wherein the controller device is mounted on the mounting rail. This is beneficial as it allows controlled and secure attachment of the controlled device.

In some variants, the mounting rail is arranged between the controller device and the breakout assembly board. This is beneficial as it allows access to the controller device without having to remove the breakout assembly board.

In some variants, the mounting rail is a DIN rail. This is beneficial as DIN rail mounts is a commonly used mount for controller devices allowing cheap, off the shelf, controller devices to be used and securely fastened to the controller cabinet.

In some variants, the controller cabinet further comprises at least one cable duct. The cable duct is arranged at one or more inner side surfaces of the controller cabinet and configured receive exterior cables from an outside of the controller cabinet. The cable duct is provided with a plurality of slots facing an inside of the controller cabinet for routing of interior cables comprised in the exterior cables, from the cable duct to connection blocks of the breakout assembly board. The cable duct is beneficial as it assist in providing neat and tidy routing inside the controller cabinet reducing installation time and a risk for mistakes during installation.

In some variants, each of the plurality of ports of the controller device is connected to one port connector of the breakout assembly board. This is beneficial as it allows simple and quick connection between the breakout assembly board and the controller device reducing time for pre-fabrication.

In some variants, the breakout assembly board comprises at least one fuse arranged in series between one or more connection block and one or more power supply ports of the controller device. This is beneficial as it increases the reliability and quality of the controller cabinet.

In some variants, wherein the breakout assembly board comprises at least one relay arranged in series between two connection block and the breakout assembly board is configured such that the at least one relay is controllable from one or more ports of the controller device. This is beneficial as it allows for the controller device to control external circuits in a galvanically isolated manner without having to spend time on adding external relays and routing, whereby time during both pre-fabrication and installation is reduced.

In some variants, the controller cabinet further comprises a power supply device electrically connected to two or more connection blocks of the breakout assembly board. This is beneficial as no external power supply for e.g. the controller device is required, reducing installation time at the building.

In some variants, the breakout assembly board is attached to an inner surface of the controller cabinet. This is beneficial as it provides a stable and secure attachment of the breakout assembly board.

In some variants, a center-to-center distance between the two adjacent connection blocks of the breakout assembly board is greater than a center-to-center distance between two adjacent ports of the controller device. This is beneficial as it simplifies access to the ports and reduces a risk of mistakes due to a too tight design.

In a third aspect, a controller cabinet system is presented. The controller cabinet system comprises a controller cabinet of the second aspect and a plurality of interior cable markers. Each interior cable marker is associated with one specific connection block of the breakout assembly board and being configured to be attached to an interior cable inside the controller cabinet. This is beneficial as the interior cable markers being provided with the controller cabinet reduces installation time at the building.

In some variants, the breakout assembly board comprises a plurality of function blocks and the controller cabinet system further comprises a plurality of exterior cable markers. Each exterior cable marker is associated with one specific function block of the breakout assembly board and being configured to be attached to an exterior cable outside the controller cabinet. This is beneficial as the exterior cable markers being provided with the controller cabinet reduces installation time at the building.

In some variants, the controller cabinet system further comprises an IO-map template for indicating connections between exterior cables and connection blocks of the breakout assembly board. This is beneficial as it simplifies documentation and reduces a risk of mistakes.

### BRIEF DESCRIPTION OF THE DRAWINGS

Embodiments of the invention will be described in the following; references being made to the appended diagrammatical drawings which illustrate non-limiting examples of how the inventive concept can be reduced into practice.
Fig. 1A is a is a schematic view of a building according to some examples of the present disclosure;
Fig. 1B is a is a block diagram of a building according to some examples of the present disclosure;
Fig. 2 is a schematic view of a controller cabinet according to some examples of the present disclosure;
Fig. 3a is a block diagram of a controller cabinet according to some examples of the present disclosure;
3b is a block diagram of a building comprising a controller cabinet according to some examples of the present disclosure;
Fig. 4 is a block diagram of a controller cabinet according to some examples of the present disclosure;
Fig. 5 is a block diagram of a breakout assembly board according to some examples of the present disclosure;
Fig. 6 is a perspective view of a breakout assembly board according to some examples of the present disclosure;
Figs. 7A and 7B are planar views of a controller device according to some examples of the present disclosure;
Fig. 8 is a schematic view of a controller cabinet according to some examples of the present disclosure;
Fig. 9A is a schematic view of a controller cabinet connected to external devices according to some examples of the present disclosure;
Fig. 9B is a partial view of exterior cabling according to some examples of the present disclosure;
Fig. 9C is a partial view of interior cabling according to some examples of the present disclosure; and
Fig. 10 is a block diagram view of a controlled cabinet system according to some examples of the present disclosure.

### DETAILED DESCRIPTION OF EMBODIMENTS

Hereinafter, certain embodiments will be described more fully with reference to the accompanying drawings. The invention may, however, be embodied in many different forms and should not be construed as limited to the embodiments set forth herein; rather, these embodiments are provided by way of example so that this disclosure will be thorough and complete, and will fully convey the scope of the invention, such as it is defined in the appended claims, to those skilled in the art.

The term "coupled" is defined as connected, although not necessarily directly, and not necessarily mechanically. Similarly, the term "connected", or "operatively connected", is defined as connected, although not necessarily directly, and not necessarily mechanically. Two or more items that are "coupled" or "connected" may be integral with each other. The terms "a" and "an" are defined as one or more unless this disclosure explicitly requires otherwise. The terms "substantially", "approximately" and "about" are defined as largely, but not necessarily wholly what is specified, as understood by a person of ordinary skill in the art. The terms "comprise" (and any forms thereof), "have" (and any forms thereof), "include" (and any form thereof) and "contain" (and any forms thereof) are open-ended linking verbs. As a result, a method that "comprises", "has", "includes" or "contains" one or more steps, possesses those one or more steps, but is not limited to possessing only those one or more steps.

Historically, controller cabinets for building automation have generally been customized for each project (e.g. building) depending on desired functionality. This entails pre-fabrication that comprises providing a specific design for each project and manual assembly of a controller cabinet that meets the specific design. During the design, a controller cabinet is exclusively specified and specific construction drawings (e.g. schematics, layout drawings, CAD-models etc.) are provided based on the desired functionality e.g. based on a controlled device selected for the controller cabinet. When the construction drawings are finalized, an empty controller cabinet is ordered together with components needed for that specific cabinet. Such controller cabinets are assembled and connected electrically before delivery to the customer. During assembly, of the controller cabinet, the components are mounted inside the controller cabinet and the components are connected by manually wiring according to the construction drawings. All the cables and wires ("cable" and "wire" will be used interchangeably throughout the present disclosure) internal to the controller cabinet are marked and markings/labels for external cables are ordered specifically for the cabinet.

This process of providing a controller cabinet is very time consuming and significant amounts of time is spent on testing the controller cabinet before delivery to ensure all connections are correct, and lacks flexibility of operation.

The present disclosure presents a controller cabinet that significantly reduces a time required both during pre-fabrication, i.e. design and assembly, and during installation at a specific building. In particular, a configurable controller cabinet is provided that can be connected to various different programmable controllers and regulators for different functions/systems of a building. As before, based on the desired functionality, a controller device is selected but rather than having to provide specific construction drawings, a controller cabinet according to the present disclosure is ordered based on the controlled device. According to some examples of the disclosure, the controller cabinet comprises all functionality the selected controlled device is configured to provide. For instance, all terminal blocks for every possible external component may be provided by the controller cabinet upon delivery. Construction drawings are done once, and pre-fabrication of a controller cabinet according to the present disclosure may be provided about ten times faster than a historical control cabinet as presented above, and will reduce the cost and increase the quality of pre-fabrication and installation. One reason for this is that substantially no electrical wiring is required during pre-fabrication and in addition to this, markings available for external cables will be common to all buildings. The markings for external cables may be provided together with the controller cabinet, optionally paired with IO-lists and/or quality documents for installation. Self-inspection before delivery is minimized, and the cabinet does not require reconfiguration for added or changed functions.

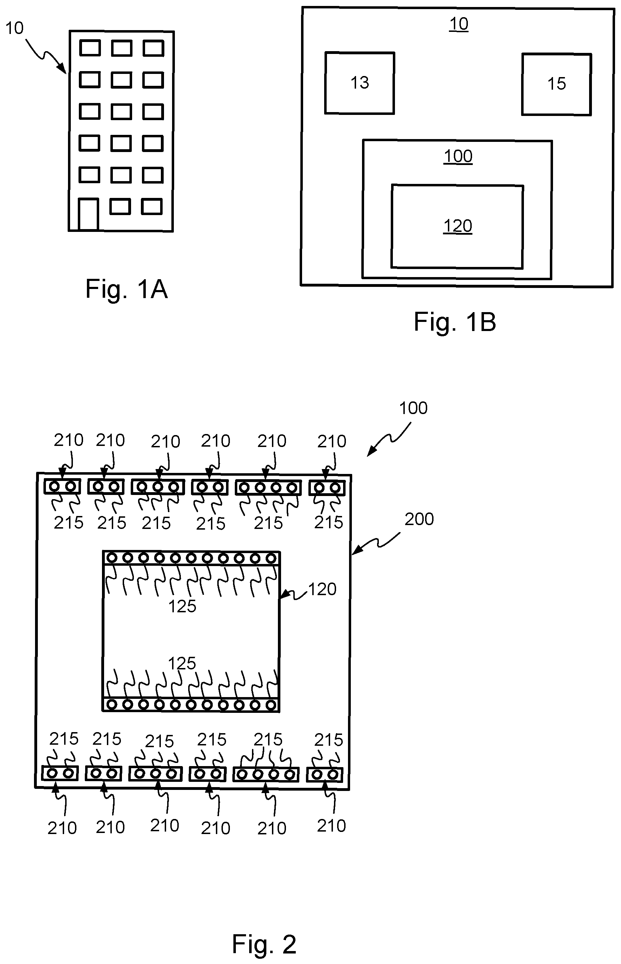

In Fig. 1A, an exemplary building 10 is shown. The building 10 may be any suitable building 10 such as a domestic building, residential building, a commercial building or combinations thereof. In Fig. 1B, a block diagram of the building 10 is shown wherein the building 10 comprises a controller cabinet 100. The building 10 further comprises different functions 13, 15. The functions 13, 15 are, from a perspective of the controller cabinet 100, external functions 13, 15. These functions 13, 15 may be exemplified by, but not limited to, sensors 13 or actuators 15.

The sensors 13 may be any suitable sensor circuitry utilized for building automation, building management or building control. For the present disclosure, the terms building automation, and building control may be interpreted as building management. These sensors 13 are arranged to detect, sense, measure or otherwise obtain data relating to various parameters within the building 10 and provide inputs to a building management systems. The sensors 13 may comprise temperature sensors arranged to measure an ambient temperature at different areas of the building 10. Temperature sensors assist in maintaining optimal temperature levels and enable HVAC systems to adjust heating or cooling accordingly. The sensors 13 may comprise humidity sensors arranged to measure a moisture content in the air of the building 10. Humidity sensors assist in controlling indoor humidity levels and preventing issues such as mold growth or discomfort for occupants. The sensors 13 may comprise pressure sensors arranged to measure a water or air pressure. Pressure sensors may be used to measure air pressure in ducts, pipes, and HVAC equipment. Pressure sensors may be installed in air handling systems to measure and provide data for regulation of air-pressure and/or airflow, measure pressure drops across filters etc. Pressure sensors may be employed in building automation to monitor water pressure in pipes and plumbing systems. The sensors 13 may comprise occupancy sensors arranged to detect presence or absence of people in a particular area of the building 10. Occupancy sensors may be used to assist in control of lighting, HVAC, and/or security systems, ensuring that e.g. energy is not wasted in unoccupied spaces. The sensors 13 may comprise carbon dioxide (CO₂) sensors arranged to monitor a level of CO₂ in the air of the building 10. Elevated CO₂ levels may indicate poor ventilation. These sensors 13 assist in optimizing ventilation systems for maintaining good indoor air quality. The sensors 13 may comprise light sensors, such as photocells or lux sensors, arranged to measure the intensity of light in a space. Light sensors assist in enabling automatic adjustment of artificial lighting based on natural light availability, contributing to energy efficiency and comfort for occupants. The sensors 13 may comprise motion sensors arranged to detect movement within an area of the building 10. Motion sensors are generally used for e.g. security purposes (triggering alarms or activating surveillance systems when unauthorized motion is detected), control of lighting, ventilation etc. The sensors 13 may comprise smoke and/or fire detectors arranged to detect presence of smoke, fire, and/or heat. Smoke and/or fire detected are generally utilized to trigger a fire alarm systems. Smoke and/or fire detectors play an important role in early detection and quick response to potential fire incidents. Smoke and/or fire detectors may be connected to external controllers to form a separate, local, circuitry for fire alert that control air vents, sprinklers etc. in case of fire. The sensors 13 may comprise water leakage sensors arranged to detect the presence of water or excessive moisture in areas of the building 10 that are prone to leaks, such as bathrooms, basements, or mechanical rooms. Water leakage sensors provide early warnings to mitigate potential water damage risks. The sensors 13 may comprise gas sensors arranged to detect the presence of hazardous gases such as carbon monoxide (CO), natural gas (methane), or volatile organic compounds (VOCs). Gas sensors assist in maintaining indoor air quality and safety and may be utilized to trigger evacuation systems.

The actuators 15 may be any suitable actuator circuitry utilized for building automation and control. These actuators 13 are arranged to control, alter, set or otherwise physically act on the building's systems or components to carry out specific actions. The actuators 15 may comprise valve actuators arranged to control a flow of fluids (e.g., water or air) in HVAC systems, heating systems, or water supply networks of the building 10. The valve actuators may open, close, or modulate valves to regulate the flow and temperature of the fluids, thus maintaining optimal conditions within the building 10. The valve actuator may further control opening and closing of sprinkler system valves, activation of fire suppression systems during fire emergencies etc. The actuators 15 may comprise damper actuators arranged to adjust a position of e.g. dampers in HVAC systems, such as air handling units or ventilation systems. By modulating the damper's opening, these actuators may regulate airflow, allowing for precise control of temperature and ventilation. The actuators 15 may comprise general motorized actuators arranged for automation of various building functions, such as opening and closing windows, doors, blinds, or curtains. The motorized actuators may assist in managing natural light, glare, and solar heat gain, contributing to energy efficiency and occupant comfort. The actuators 15 may comprise lighting actuators arranged to control artificial lighting systems, such as turning lights on or off, dimming lights, or adjusting light levels based on occupancy and natural light availability. The lighting actuators may assist in optimizing energy usage and creating a comfortable environment. The actuators 15 may comprise pump actuators arranged to regulate operation of pumps in water distribution systems, hydronic heating systems, or cooling systems. The pump actuators may adjust the pump's speed or flow rate to match a demand of the building 10 and thereby promoting energy efficiency. The actuators 15 may comprise fan actuators arranged to control a speed and operation of fans in e.g. HVAC systems, enabling precise adjustments to the airflow and ventilation requirements. The actuators 15 may comprise security actuators arranged to control access control mechanisms, such as locking and unlocking doors, gates, or turnstiles, based on e.g. authorization and occupancy status. The actuators 15 may comprise actuators arranged to control operation of chillers and boilers in central cooling and heating plants of the building 10. Such actuators 15 adjust the chiller's or boiler's output based on the building's demand, enhancing energy efficiency.

In addition to, or as an alternative to, the sensors 13 and actuators 15 exemplified above, the building 10 may comprise numerous additional devices, circuits or arrangement for building automation and control. The building 10 may comprise human-machine interfaces (HMIs) arranged to provide a user-friendly interface for building operators, managers or occupants to interact with the building automation system. The HMIs may be configured to display real-time data, control options, and alarms, enabling users to monitor and adjust building automation systems efficiently. The building 10 may comprise energy meters measure the consumption of electricity, gas, water, heat (e.g. a difference in incoming and outgoing temperature of district heating) or other utilities within the building providing data for energy management and assist in identifying areas where energy efficiency may be improved. The building 10 may comprise data loggers arranged to collect and store data from sensors and other devices over time. Data loggers may assist in analyzing historical performance and trends, assisting in predictive maintenance and identifying areas for improvement.

All the devices mentioned above are generally controlled by a controller device 120 of the building 10. The controller device 120 may be configured to obtain data from the sensors 13 and control the actuators 15 based on the sensor data. To this end, the controller device 120 is, at least operatively, connected to each of the sensors 13, actuators 15 and other additional devices utilized for control and/or automation of the building 10. Most devices are connected to the controller device 120 by wires and require at least two wires (one signal and one reference) for reliable communication and control. Consequently, wiring at the controller device 120 will be extremely dense and complex which makes connection of wires time consuming and a risk of errors is significant.

Generally, the controller device 120 is provided mounted in the controller cabinet 100. As previously mentioned, controller cabinets have historically been customized for a specific building 10 and have been specifically pre-fabricated for that building. The controller cabinet 100 may comprise arrangement and devices (power supplies, fuses, relays etc.) as is generally configured to accommodate functionality required by the specific building 10. Historically, pre-fabrication of a controller cabinet requires significant time and documentation of historic pre-fabricated connections of the controller cabinet are provided independently of the connections provided at the building 10, thereby increasing a risk of errors and causing extra effort by both personnel pre-manufacturing the controller cabinet, and personnel installing the controller cabinet at the building.

It should be mentioned that there are generally requirements on installed controlled cabinets 100 that all cabling entering the controller cabinet 100 should be marked outside the controller cabinet 100 to indicate what device, e.g. sensor 13, actuator 15, each cabling is connected to. In addition to this, all cabling inside the controller cabinet should be marked with the specific port of the controller device 120 that each specific cable should be connected to. This simplifies maintenance, trouble shooting and modifications of a system for building automation. Marking all cables is time consuming and generally expensive as customized labels may be required which may not be possible to define (or order) before the controller cabinet 100 is fully installed at the building 10.

To give a simple example, assume a three-storey apartment building where lights at each floor are to be turned on only if there is a person at that floor. To solve this, a controller device 120 is installed in a controller cabinet 100 at a basement level of the building. Motion detectors are installed at landings of each floor and at hallways leading to the apartments at that floor. Assume three motion detectors per floor which gives a total of nine motion detectors. Each motion detector requires power and generates a control signal (active high or low) in response to detection of movement. In total three cables are required for each motion detector (one for data and two for power) meaning that 27 cables arrive at the controller cabinet from the motion sensors. Each floor is provided with local multiway switching for control of the lights. In order to open and close the multiway switch circuits at each floor, the controller device 120 will have to selectively open and close the mains voltage multiway switching circuits at each floor. This may be accomplished by routing each multiway switch circuit to the controller device 120 and back again providing two cables per floor. Controller devices 120 generally operate at DC voltages below 40 V and are not configured to control mains voltages. To this end, three relays are controlled by the controller device 120, one relay per multiway switch circuits, allowing the controller device 120 to directly control the relays rather than the mains voltage. The control signals from each of the motion detectors are routed into the controller cabinet 100 and connected to digital inputs of the controller device 120. The controller cabinet 100 is provided with a power supply which is connected to the controller device 120 and each of the motion detectors, requiring at least ten cables connected to a positive feed of the power supply and ten cables connected to a ground reference (e.g. signal ground or other common reference) of the power supply. Generally, connection blocks of the power supply will not accommodate this many cables and splits with external connection blocks will be required inside the controller cabinet. The relays for controlling the multiway switch circuits are, at a control side, connected to digital outputs or driver outputs of the controller device 120 and a ground reference of the power supply (requiring further external connection blocks). The digital inputs associated with the three motion detectors of each floor are associated with the digital outputs connected to the relay controlling the multiway switch circuits of that floor during programming of the controller device 120.

From this seemingly simple example, it is evident that the complexity of connecting and keeping track of all cables at the controller cabinet 100 is extremely challenging and time consuming. The requirement to use connection blocks inside the controller cabinet 100 cause extra wiring and increase complexity of the controller cabinet 100. As mentioned, a controller cabinet for the specific example above would be a specialized controller cabinet requiring detailed specification before ordering and knowledge of the system to be controlled at the building 10 both during pre-fabrication and installation.

In Fig. 2 a planar view of a controller cabinet 100 is shown. The controller cabinet 100 in Fig. 2 is shown looking into the controller cabinet 100 from an access side, generally a front of the controller cabinet 100. The front of the controller cabinet 100 is preferably covered with an openable door (not shown), the openable door may be lockable. In some examples, the controller cabinet 100 is accessed via a removable hatch that may be removably attached to the controller cabinet 100 by one or more screws, a twist-lock etc. A housing of the controller cabinet 100 may be a metallic housing, a plastic housing or a combination of metal and plastic. In some examples, the housing is a metal housing and a door or a hatch of the housing is a plastic lid.

The controller cabinet 100 in Fig. 2 comprises a controller device 120. The controller device 120 may be any controller device suitable for building control and/or automation. The controller device 120 may be exemplified by a programmable logic controller (PLC) or a direct digital controller (DDC) but the skilled person will appreciate that the teachings presented herein are applicable to any controller device 120 for building control and/or automation. In some examples, the controller device 120 may be a Corrigo^{Ardo} controller device by REGIN. In some examples, the controller device 120 may be an Exigo^{Ardo} controller device by REGIN.

The controller device 120 comprises a plurality of ports 125. Each port 125 is generally a port having a specific functionality such as digital inputs, analogue inputs (connected to an AD converter of the controller device 120), digital outputs, analogue outputs (connected to a DA converter of the controlled device 120), power input, general purpose inputs (GPI), general purpose outputs (GPO), general purpose inputs/outputs (GPIO) etc. These ports 125 are what e.g. sensors 13 and actuators 15 are to be connected to.

The controller device 120 may comprise any numbers of ports 125. A controller device 120 may, in part, be defined by a number of input/output (I/O) ports offered by the controlled device 120. In some examples, the controller device 120 comprise between 10 and 50 I/O port, preferably between 15 and 40 I/O ports, and most preferably 28 I/O ports.

In order to simplify connection of the ports 125 to different functions 13, 15 of the building 10, the controller cabinet 100 is Fig. 2 is provided with a breakout assembly board 200. The breakout assembly board 200 comprises a plurality of connection blocks 215. The connection blocks 215 may be referred to as terminal blocks or termination blocks but the skilled person appreciates that the naming is not to be considered limiting. The breakout assembly board 200 will comprise wiring (routing) allowing the connection blocks 215 to be connected to the ports 125 of the controller device 120. One port 125 of the controller device 120 may be connected to more than one connection block 215. Advantageously, each of the connection blocks 215 is labeled in order to simplify installation and reduce a risk of mistakes. Labels of the connection blocks 215 may be provided by stickers and/or markings (e.g. silkscreen, soldermask) on a printed circuit board (PCB) mounting the connection blocks 215.

In Fig. 2, the connection blocks 215 are arranged along edges of the breakout assembly board 200 which simplifies access to the connection blocks 215. In some examples, one or more connection blocks 215 be provided at any other suitable location of the breakout assembly board 200. Preferably, all connection blocks 215 are provided on the same planar face (i.e. top/bottom of a PCB) of the breakout assembly board 200. This allows easy access to all connection blocks 215. However, in some examples, connection blocks 215 may be provided on both sides of the breakout assembly board 200. This may be beneficial where e.g. some connection blocks 215 are configured for functionality or installation of cabling only handled during pre-manufacturing of the controller cabinet 100. Such connection blocks 215 may be placed at a harder to access side of the breakout assembly board 200, generally a bottom side of the breakout assembly board 200.

The ports 125 of the controller device 120 may be connected to the breakout assembly board 200 in any suitable way. In some examples, first ends of wires are soldered onto the breakout assembly board 200 and second ends of the wires are connected to ports 125 of the controller device 120. In some examples, the breakout assembly board 125 comprises a socket (not shown) configured to house the controller device 120 and provide connections from the ports 125 of the controller device 120 to routing of the breakout assembly board 200. The socket may provide mechanical and electrical connection between the controller device 120 and the breakout assembly board 200 (or rather a printed circuit board of the breakout assembly board 200).

The controller cabinet 100 in Fig. 2 provides a device that is quick to install as the installer is not required to fiddle with the tight and sometimes poorly marked ports 125 of the controller device 120. The controller cabinet 100 is quick to pre-fabricate as one controller cabinet 100 may be utilized by several buildings 10. Customization of the controller cabinet 100 is performed without additional time or resources at the building 10 rather than, as today, both at the building 10 and during pre-fabrication. The controller cabinet 100 is easy to specify and order for customers interested in building automation, the controller cabinet 100 may offer all functionality of the controller device 120 without additional installation, configuration or specification during order. The controller cabinet 100 reduces sources of errors as a preconfigured, verified and tested breakout assembly board 200 is utilized for intermediate connections between the controller device 120 and external functions 13, 15. The number of connections manually provided may be decreased as no internal splitting connectors are required which reduces a risk for mistakes during pre-manufacturing and installation. The controller cabinet 100 increases quality of building management systems and reduces costs of pre-manufacturing and installation of building management systems. As there is no requirement of external splits or the like, he controller cabinet 100 in Fig. 2 is considerably lighter than prior art controller cabinets providing a better work environment for installers installing the controller cabinet 100 at the building 10.

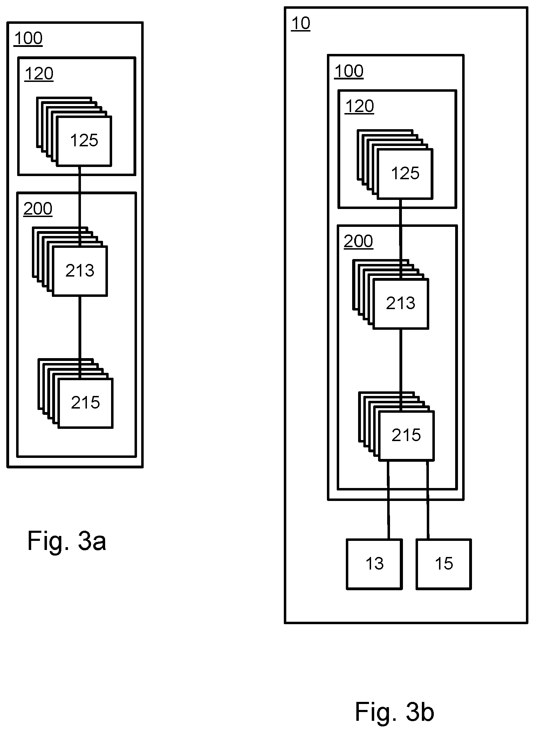

In Fig. 3a, a block view of a controller cabinet 100 is shown. The controller cabinet 100 comprises the controller device 120 and the breakout assembly board 200. The plurality of ports 125 of the controller device 120 are configured to provide a connection to the port connectors 213 of the breakout assembly board 200. In this way, the breakout assembly board 200 is connectable to the controller device 120. The port connectors 213 are connected to connection blocks 215 of the breakout assembly board 200.

In Fig. 3b, a block view of the controller cabinet 100 in Fig. 3a is shown in the context of a building 10. As shown in Fig. 3b, the building 10 comprises one or more functions 13, 15 to be controlled by the controller cabinet 100. The functions 13, 15 are connected to the connection blocks 215 of the breakout assembly board, for example via cabling between the connection blocks 215 and external devices related to the functions 13, 15. In this way, the breakout assembly board 200 is connectable to the one or more functions 13, 15. This construction enables the controller device 120 to be operatively connected to the one or more functions 13, 15 via the breakout assembly board 200. In particular, the plurality of ports 125 of the controller device 120 may be connected to the port connectors 213 of the breakout assembly board 200, which are connected to connection blocks 215 of the breakout assembly board 200, which may be connected to the one or more functions 13, 15. The controller device 120 may then be used for building control and/or automation.

Generally, each port 125 of the controller device 120 is connected to one port connector 213 of the breakout assembly board 200, but each port connector 213 may be connected to more than one connection block 215. To this end, in some examples, the breakout assembly board 200 comprises more connection blocks 215 than port connectors 213. In other words, a number of connection blocks 215 of the breakout assembly board 200 may be greater than a number of port connectors 213 of the breakout assembly board 200.

In some examples, the port connectors 213 are connectable by mating connectors and the ports 115 of the controller are connectable by mating connectors. In such examples, cables comprising a mating connector for the port connector 213 at one end and a mating connector for the ports 115 at the other end may connected between the ports 115 and the port connectors 213. In some examples, the breakout assembly board 200, or the controller cabinet 100 are provided with the cables comprising the mating connector for the port connector 213 at one end and the mating connector for the ports 115 at the other end.

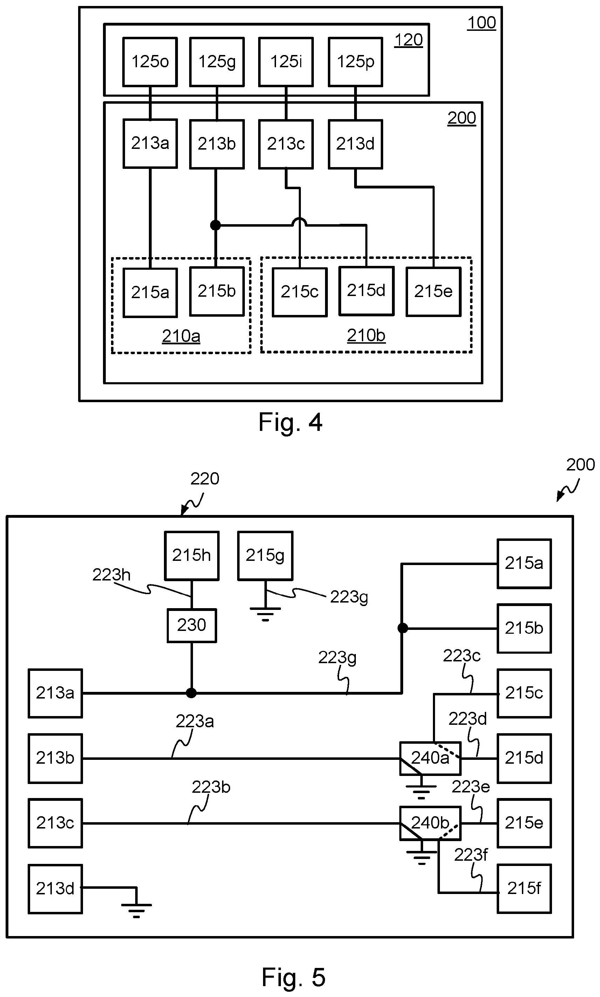

An exemplary relationship between the ports 125, port connectors 213 and connection blocks 215 is illustrated in the block view of a controller cabinet 100 shown in Fig. 4. In Fig. 4, an exemplary controller device 120 is shown comprising four ports 125o, 125g, 125a, 125i. The controller device 120 comprises an output port 125o, a signal ground port 125g, an input port 125i and a power port 125p. Each of the four ports 125o, 125g, 125a, 125i are connected to a respective port connector 213a, 213b, 213c, 213d of the breakout assembly board 200. In Fig. 4, the output port 125o is connected to a first port connector 213a of the breakout assembly board 200, the ground port 125g is connected to a second port connector 213b of the breakout assembly board 200, the input port 125i is connected to a third port connector 213c of the breakout assembly board 200 and the power port 125p is connected to a fourth port connector 213d of the breakout assembly board 200. In some examples, not all ports 125 of the controller device 120 are connected to port connectors 213 of the breakout assembly board 200. Preferably, each port 125 of the controller device 120 is connected to one port connector 213 of the breakout assembly board 200 as this allows for easy access and installation of all functionality offered by the controller device 120. In Fig. 4, the breakout assembly board 200 comprises five connection blocks 215a, 215b, 215c, 215d, 215e each connected to one port connector 213a, 213b, 213c, 213d. A first connection block 215a is connected to the first port connector 213a and thereby the digital output port 215o of the controller device 120. A second port connector 215b and a fourth port connector 215d are both connected to the second port connector 213b and thereby the ground port 125g of the controller device 120. A third connection block 215c is connected to the third port connector 213c and thereby the input port 125i of the controller device 120. A fifth connection block 215e is connected to the fourth port connector 214d and thereby the power port 125p of the controller device 120.

In Fig. 4, the connection blocks 215a, 215b, 215c, 215d, 215e are grouped in function blocks 210a, 210b. The connection blocks 215a, 215b, 215c, 215d, 215e of each function block 210a, 210b are advantageously physically close to each other. In some examples, each function block 210a, 210b is one connector comprising a plurality of connection blocks 215a, 215b, 215c, 215d, 215e, e.g. a multi terminal connection block. Preferably, as exemplified in Fig. 4, the connection blocks 215a, 215b, 215c, 215d, 215e of each function block 210a, 210b are adjacent to each other. Each function block 210a, 210b is preferably associated with one specific function although several function blocks 210a, 210b may offer corresponding functions. In Fig. 4, an exemplary first function block 210a is formed by grouping of the first connection block 215a and the second connection block 215b. The first function block 210a provides a simple interface to, from the output port 125o of the controller device 120, control e.g. external actuators 15. In Fig. 4 an exemplary second function block 210b is formed by grouping of the third connection block 215c, the fourth connection block 215d and the fifth connection block 215e. The second function block 210b provides a simple interface to, at the input port 125i of the controller device 120, detect if a motion sensor is triggered or obtain readings from any other external sensor 13.

The provisioning of function blocks 210 greatly simplifies both pre-fabrication and installation of the controller cabinet 100. In the example given above with light control, each of the nine motion detectors may be assigned one specific function group 210 and the associated wiring for each motion detector would be easily connected to its assigned function group.

The breakout board assembly 200 may comprise further features than routing, connection blocks 215 and the optional port connectors 213. In Fig. 5, an exemplary breakout board assembly 200 is shown. The breakout board assembly 200 in Fig. 5 comprises a PCB 220, a fuse 230 and relays 240a, 240b. In other examples, fuses 230 but no relays 240 are provided or relays 240 are provided but no fuses 230. The breakout assembly board 200 may comprise any suitable number or relays 240, preferably the breakout assembly board 200 comprises between 1 and 15 relays 240, more preferably, the breakout assembly board 200 comprises between 5 and 10 relays 240. The breakout assembly board 200 may comprise any suitable number or fuses 230, preferably the breakout assembly board 200 comprises between 1 and 8 fuses 230, more preferably, the breakout assembly board 200 comprises between 1 and 5 fuses 230.

The PCB 220 may be a single layer PCB, a double sided PCB or a multi-layer PCB. The connection blocks 215a, 215b, 215c, 215d, 215e, 215f, 215g and port connectors 213a, 213b, 213c, 213d are mounted on the PCB 220. The connection blocks 215a, 215b, 215c, 215d, 215e, 215f, 215g and port connectors 213a, 213b, 213c, 213d may be mounted on the PCB 220 by surface mount or hole-mount. The PCB 220 further comprises conductive traces (e.g. wiring, routing) 223a, 223b, 223c, 223d, 223e, 223f, 223g, 223h between the devices of the PCB 220. The conductive traces 223a, 223b, 223c, 223d, 223e, 223f, 223g, 223h may be provided in any layer of the PCB 220. Routing between layers may be provided by one or more vias.

The relays 240 are electromechanical devices that act as electrically controlled switches, and they are beneficial in automating and controlling of electrical circuits such as actuators 15. Relays 240 provide electrical isolation between the controller device 120 and the controlled circuit, e.g. a sensor 13 or an actuator 15. This isolation ensures that any high-voltage or high-current components of the controlled circuit does not directly affect the controller device 120. Relays 240 enhances safety by minimizing the risk of electrical shock or damage to sensitive control components. Relays 240 enable control of high-power or high-current devices with low-power control signals. For example, a small (weak) control signal from the controller deice 120 may activate a relay, allowing the controller device 120 to switch on or off much larger loads, such as motors, heaters, or lights. Relays 240 may function with a wide range of voltages and currents. This makes relays 240 compatible with different types of external devices. Relays 240 may handle comparably high-current loads, making relays 240 suitable for controlling devices that require significant power, such as large motors, compressors, and industrial equipment.

Relay control is preferable when mains voltages (e.g. 230 V AC) are controlled as requirements on e.g. isolation distances and current handling on the PCB 220 are reduced compared to if mains voltages were to be routed on the PCB 220.

Fuses 230 are generally comparably simple, passive electrical component designed to break a circuit and stop the flow of current when it exceeds a certain level. One function of a fuse 230 is to provide overcurrent protection. When a current in a circuit exceeds a rated value of the fuse 230, the fuse 230 element inside the fuse 230 melts or blows, breaking the circuit. This prevents excessive current from damaging the devices or components connected to the circuit. By interrupting the circuit during an overcurrent event, fuses 230 help prevent overheating and potential fires caused by excessive current flowing through the wires or devices. Fuses 230 act as a safety measure to reduce fire hazards in electrical systems.

Fuses are preferably arranged on power signals providing power to the controller device 120. In some examples, fuses 230 are arranged on signals connected to external functions 13, 15 in order to protect the breakout circuit board 200, the controller device 120, and/or the controller cabinet 100 from over current issues.

In Fig. 5, the breakout assembly board 200 is configured to receive power at a seventh connection block 215h and an eighth connection block 215g. The eighth connection block 215g is connected to a ground plane of the PCB 220 increasing decoupling capabilities, decreasing a risk of issues with EMI/EMC and simplifying routing of the PCB 220. The term ground plane should be interpreted as a layer, or a part of a layer of the PCB 220 having a common reference potential such as signal ground, a negative feed, a control voltage etc. The seventh connection block 215h, a positive feed terminal, is connected to a first terminal of the fuse 230 by a seventh conductive trace 223h. A second, opposite, terminal of the fuse 230 provides power to a first port connector 213a and first and second connection blocks 215a, 215b via an eighth conductive trace 223g. A first conductive trace 223a connects a second port connector 213b to a first control terminal of a first relay 240a. A second control terminal of the first relay 240a is connected to the ground plane. A first controlled terminal of the first relay 240a is connected to a third connection block 215c by a third conductive trace 223c and a second controlled terminal of the first relay 240a is connected to a fourth connection block 215d by a fourth conductive trace 223d. Similarly, a second conductive trace 223b connects a third port connector 213c to a first control terminal of a second relay 240b. A second control terminal of the second relay 240b is connected to the ground plane. A first controlled terminal of the second relay 240e is connected to a fifth connection block 215e by a fifth conductive trace 223e and a second controlled terminal of the second relay 240b is connected to a sixth connection block 215f by a sixth conductive trace 223f.

In the example of Fig. 5, a connection between the third connection block 215c and the fourth connection block 215d is controlled by the first relay 240a. This allows the controller device 120 to be galvanically isolated from circuitry connected at the third connection block 215c and the fourth connection block 215d. The corresponding is true for the connection between the fifth connection block 215e and the sixth connection block 215f which is controlled by the second relay 240b.

In the example of Fig. 5, a common ground plane was utilized to distribute a common reference potential across the PCB 220. In other examples, separate ground references are utilized for different functions. For instance, an analogue ground may be common to all analogue function blocks 210, a digital ground may be common to all digital function blocks 210 and/or a power ground may be common to all power function blocks 210. Separate ground references reduces a risk of generally noisy digital signals interfering with generally sensitive analogue signals. Further to this, separate ground references allows decoupling and other filtering to be optimized for each specific function. As mentioned, the term ground should be interpreted as any common reference.

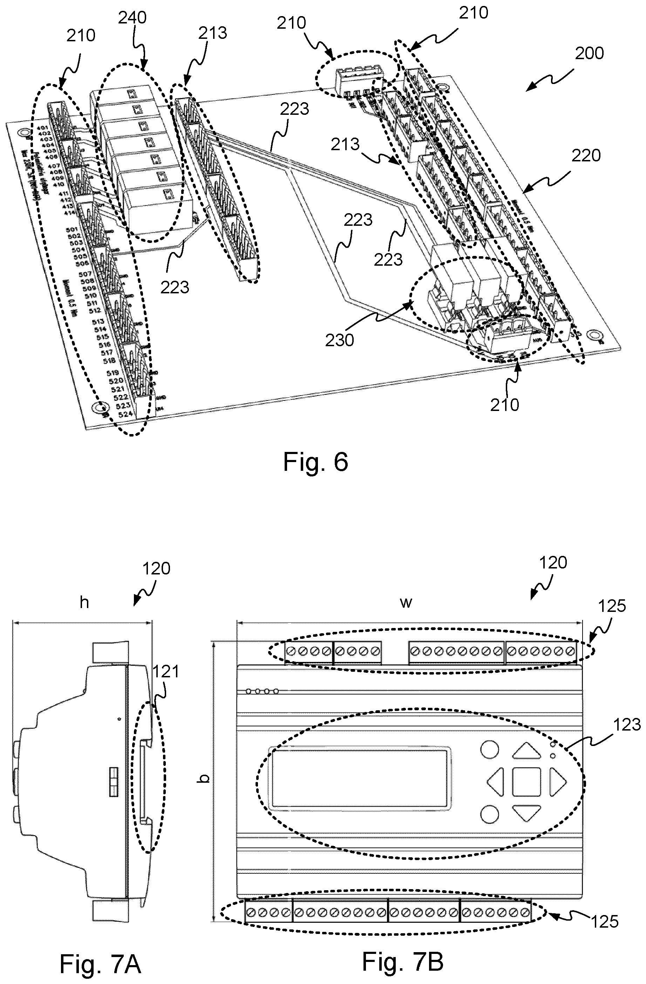

In Fig. 6, a preferred example of a breakout assembly board 200 is shown. The breakout assembly board 200 is configured for forming part of a controller cabinet 100 as presented herein. The breakout assembly board 200 comprises a plurality of function blocks 210, each function block 210 comprises two or more connection blocks 215 (not indicated in Fig. 6). The breakout assembly board 200 further comprises port connectors 213 configured to be connected to ports 125 (not shown in Fig. 6) of a controller device 120 (not shown in Fig. 6). The breakout assembly board 200 further comprises fuses 230 arranged to provide over voltage and/or over current protection on incoming power. The breakout assembly board 200 further comprises relays 240 and the PCB 220 comprises conductive traces 223 providing interconnect between the features of the breakout assembly board 200.

As seen in Fig. 6, the function blocks 210 are formed by multi-port connectors. Advantageously, the controller cabinet 100 is provided with mating connectors for the function blocks 210. The mating connectors are configured to be attached to external cabling before the mating connector is connected to the function block 210. The connection between the mating connector and the external cabling may be provided by a screw-connection at the mating connector. In some example, function blocks 210 are provided by male connection blocks 215 and the mating connectors are mating female connectors. In some example, function blocks 210 are provided by female connection blocks 215 and the mating connectors are mating male connectors. In some example, some function blocks 210 are provided by male connection blocks 215 some function blocks 210 are provide by female connection blocks and the mating connectors are mating female connectors or mating male connectors. In some example, function blocks 210 are provided by combinations of male and female connection blocks 215 and the mating connectors are a corresponding combination of mating female and male connectors. By providing at least one function block 210 as multi-port connection block such that the associated at least one function 13, 15 is connectable by a single mating connector, installation and troubleshooting is simplified as the associated at least one function 13, 15 is fast and simple to remove without having to use tools which would be the case of e.g. screw connections for the connection blocks 215.

Fig. 7A is a side view of an exemplary controller device 120 suitable for forming part of a controller cabinet 100 as presented herein. The controller device 120 is designed with a height h. A bottom side of the controller device 120 is provided with a fastening arrangement 121. In Fig. 7A, the fastening arrangement 121 is a fastening arrangement 121 configured for fastening the controller device 120 to a rail, specifically a Deutsches Institut für Normung (DIN) rail. In Fig. 7B the controller device 120 is shown from a top view visualizing the ports 125 of the controller device 120. In Fig. 7B, the ports 125 are connectable by wires that are screwed to terminals of the controller device 120. The controller device 120 may comprise a user interface 123. In Fig. 7B, the user interface is exemplified by a set of buttons and a display, but controller devices 120 having other user interfaces 123 or controller devices 120 having no user interface 123 are also compatible with the controller cabinet 100 of the present disclosure.

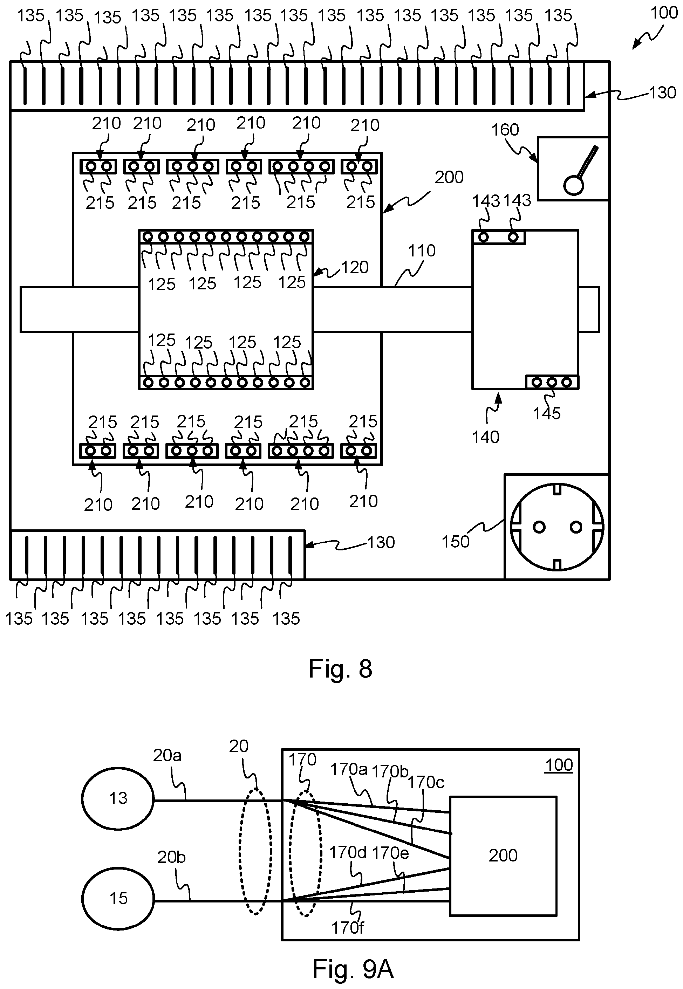

In Fig. 8, a planar view of a controller cabinet 100 is shown. The controller cabinet 100 in Fig. 8 comprise the features mentioned with reference to the controller cabinet 100 in Fig. 2 with some further optional additional features. In Fig. 8, the controller cabinet 100 comprises a mounting rail 110. The mounting rail 110 may be any suitable rail for mounting devices but advantageously, the mounting rail 110 is a DIN rail. DIN rails are standardized metal or plastic mounting rails used to mount and organize various electrical and electronic components in control panels, distribution boards, and industrial enclosures. DIN-rails conform to specific international standards, ensuring consistency and compatibility across various manufacturers and industries and many off the shelf components and devices (such as controller devices 120 for control and/or automation of a building 10) are generally configured to be mounted on a DIN rail.

The controller cabinet 100 in Fig. 8 further comprises a power supply device 140. The power supply device 140 may be mounted on the rail 110 (if present) or attached to an inside of the controller cabinet 100. The power supply device 140 comprises primary power ports 145, generally configured to be connected to line, neutral and ground of a mains supply. The power supply device 140 further comprise secondary power ports 143 at which an internal voltage of the controller cabinet 100 is provided. The internal voltage is generally selected based on requirements of the controller device 120. In some examples, there may be more than one internal voltage provided by the power supply device 140. An incoming mains supply is advantageously provided with a mains power breaker 160 arranged control a connection between incoming mains voltage and an interior of the controller cabinet 100. The mains power breaker 160 is advantageous as it allows power to be switched off for all or some devices of the controller cabinet 100 during maintenance, service and installation of the controller cabinet 100. In order to provide convenient power to tools and devices utilized by e.g. installers during installation, the controller cabinet 100 may be provided with one or more mains outlets 150. Further mains devices in addition to those shown in Fig. 8 may be provided, such as fuses, ground fault breakers etc.

The secondary power ports 143 of the power supply device 140 may be connected to connection blocks 215 of the breakout board assembly 200. Preferably, the secondary power ports 143 of the power supply device 140 are connected to a function block 210 for incoming power on the breakout assembly board 200.

Where the controller cabinet 100 is provided with a rail 110, and the controller device 120 is mounted on the rail 110, the breakout board assembly 200 is advantageously mounted behind the rail 110. This means that the rail 110 is arranged between the controller device 120 and the breakout assembly board 200. This allows unhindered access to the controller device 120 and as the breakout assembly board 200 present a larger footprint than the controller device 120, the controller device 120 will not obstruct access to the connection blocks 215 of the breakout assembly board 200.

Although not shown, the controller cabinet 100 and/or the breakout assembly board 200 may comprise further connectors, devices and functions exemplified by, but not limited to, decoupling and/or filtering component(s), serial communications interface(s), parallel communications interface(s), wireless communications interface(s), network connector(s) (e.g. RJ45 connector(s)) etc. Such interfaces may offer communications utilizing standardized protocols such as BACnet, Modbus, LonWorks, KNX, xLine etc. Such interfaces may allow the controller device 120 to connect to e.g. I/O-expanders, other controller cabinets 100 and or other port expanding features.

As seen in Fig. 8, the controlled cabinet 100 may optionally comprise one or more cable ducts 130. The cable duct 130 is provided to allow routing of wires from the connection blocks 215 to an outside of the controller cabinet 100 without unduly cluttering the interior of the controller cabinet 100 with wires. The cable duct 130 is provided with a plurality of slots 135, shown facing out from the controller cabinet 100 in Fig. 8, but advantageously facing towards an interior of the controller cabinet 100, i.e. horizontally. External electrical connections may enter the controller cabinet 100 and the cable duct 130 from an outside of the controller cabinet 100 and are routed inside the cable duct 130 to suitable slot(s) 135 in a vicinity of a connection block 215 targeted by the external electrical connection. The cable duct 130 may be provided with a lid that may be removed or opened during installation of the controller cabinet 100. The lid may be e.g. a hinged lid or a slap-lock lid.

In Fig. 9A, a schematic view of a controller cabinet 100 connected to a sensor 13 and an actuator 15 is shown. Exterior cables 20 connect the sensor 13 and the actuator 15 to the controller cabinet 100. The exterior cables 20 may be cable assemblies comprising more than one cable which is the case in Fig. 9A. A first exterior cable 20a connecting the sensor 13 to the controller cabinet 100 is, at the controller cabinet 100, split into interior cables 170, the first exterior cable 20a is split into a first interior cable 170a, a second interior cable 170b and a third interior cable 170c. Correspondingly, a second exterior cable 20b connecting the actuator 15 to the controller cabinet 100 is, at the controller cabinet 100, split into a fourth interior cable 170d, a fifth interior cable 170e and a sixth interior cable 170f. Each of the interior cables 170a, 170b, 170c, 170d, 170e, 170f are connected to one specific connection block 215 (not indicated in Fig. 9A) of the breakout assembly board 200.

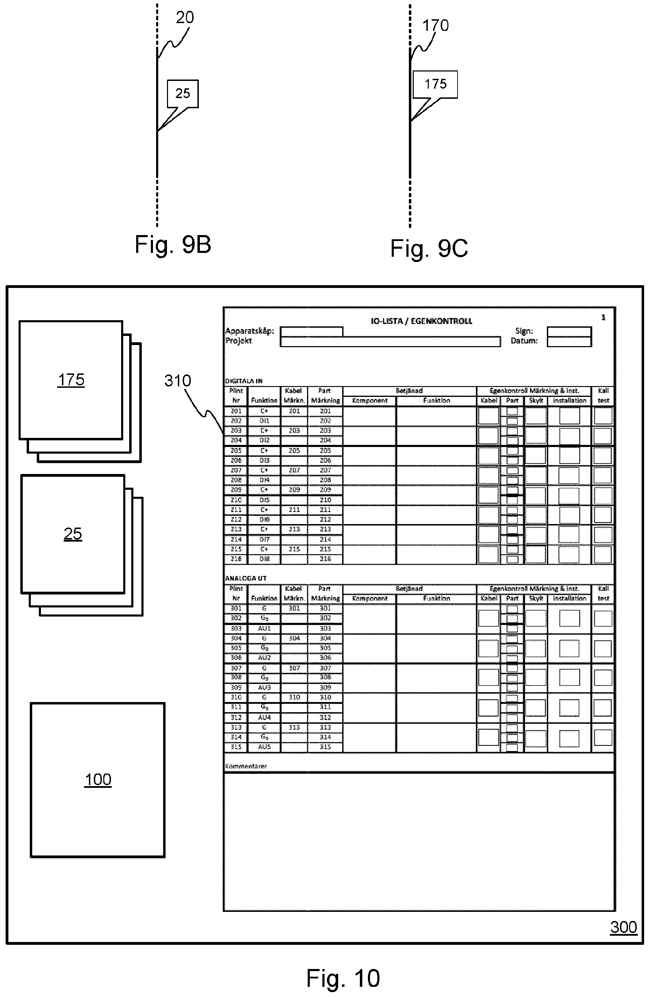

As previously mentioned, in order to simplify installation, expansion, service and maintenance, the cables 20, 170 are preferably labeled. To this end, as shown in Fig. 9B, the exterior cables 20 may be provided with exterior cable markers 25. The exterior cable markers 25 advantageously indicate a function of the associated external cable 20, and/or the function block 210 (or connection blocks 215 if function blocks 210 are not provided) of the breakout assembly board 200 and/or the ports 125 of the controller device 120 that the associated internal cables 170 is configured to be connected to. Correspondingly, as shown in Fig. 9C, the interior cables 170 may be provided with interior cable markers 175. The interior cable markers 175 advantageously indicate a function of the associated internal cable 170, and/or the connection block 215 of the breakout assembly board 200 and/or the ports 125 of the controller device 120 the internal cable 170 is configured to be connecter to.

In Fig. 10, a block diagram of a controller cabinet system 300 is shown. The controller cabinet system 300 comprises a controller cabinet 100 as described herein and is what may be an end product of pre-fabrication of the control cabinet 100. The controller cabinet system 300 may comprise a plurality of interior cable markers 175. The plurality of interior cable markers 175 preferably comprise at least one interior cable markers 175 labeled according to each of the connection blocks 215 of the control cabinet 100. This simplifies installation at the building 10 as an installer may directly mark internal cables 170 ensuring their connection is correct, saving time and increasing quality. Generally, an order for the controller cabinet system 300 will specify which external functions 13, 15 the controller cabinet system 300 should be configured to support. To this end, the plurality of interior cable markers 175 may be configured to further detail their associated external function. This further decreases installation time at the building and clarifies marking making maintenance, service and expansion faster, simpler and cheaper. Optionally, the controller cabinet system 300 may comprise a plurality of exterior cable markers 25. The plurality of exterior cable markers 25 advantageously comprise at least one exterior cable marker 25 associated with each function block 210 of the breakout assembly board 200 intended for being connected to interior cables 170 connected directly to (or forming part of) exterior cable assemblies 25. This further decreases installation time at the building and clarifies marking which makes maintenance, service and expansion faster, simpler and cheaper. Historically, exterior cable markers 25 are post ordered once installation at the building 10 is complete, adding extra process steps, delivery times and increase a risk of mistakes. By providing the exterior cable markers 25 together with the controller cabinet system 300, these delays are removed and these risks are reduced.

In order to document and keep track of e.g. connections between external devices 13, 15 and connection blocks 215, connections between external devices 13, 15 and function blocks 210 historical installations has required that documentation is provided from scratch upon finalization of installation at the building 10. The controller cabinet system 300 may, due to the breakout assembly board 200, be provided with an IO-map template 310. The IO-map template 310 indicate connections between external devices 13, 15 and connection blocks 215 of the breakout assembly board 200. The IO-map template 310 preferably comprise pre-printed data listing relevant connection blocks 215 of the breakout assembly board, their associated function, marking of internal cable marker 175 and any label printed on the breakout assembly board 200. The IO-map template 310 may further comprise open sections for each function group to be filled out by the installer during installation at the building 10. The IO-map template 310 further decrease installation time and helps ensuring that documentation is correct which reduce a risk of errors. The IO-map template 310 may further comprise further data related to testing, certification, markings etc.

In some examples, the controller cabinet system 300 may comprise mating connectors (not shown in Fig. 10) for connecting groups of internal cables 170 to specific function blocks 210.

A breakout assembly board 200 as disclosed herein can be provided that provides current paths to any relays and connection terminals that may be required. The breakout assembly board 200 is prepared with terminals to be able to supply different types of sensors that are compatible with controllers and/or regulators of the building functions. The breakout assembly board 200 may also supply voltage to the components (e.g. 24V) if necessary, as there is a dedicated terminal with voltage for each component that may need a voltage supply. Digital outputs may be connected via current relays to become potential-free and may be adapted for 230V, 5A, which is sufficient in most cases. Relays are replaceable in case they break. The breakout assembly board 200 may be mounted in an enclosure where a controller attached to a DIN rail may be connected to the breakout assembly board 200 with quick connectors. The breakout assembly board 200 may be secured with glass fuses both against the transformer and against external components that may be live.

In one example implementation of a controller cabinet 100 as disclosed herein, a breakout assembly board 200 is provided that that fits 10 different freely programmable controllers, 4 different configurable regulators for ventilation, and 5 different configurable regulators for heating and boiler control. This solution can therefore be used for 19 different controllers in a plug-and-play fashion.

Modifications and other variants of the described embodiments will come to mind to one skilled in the art having benefit of the teachings presented in the foregoing description and associated drawings. Therefore, it is to be understood that the embodiments are not limited to the specific example embodiments described in this disclosure and that modifications and other variants are intended to be included within the scope of the claims. For example, while embodiments of the invention have been described with reference to a controller cabinet for building automation and/or control, persons skilled in the art will appreciate that the embodiments of the invention can equivalently be applied to other controller cabinet where a controller device is connected to different and perhaps a configurable set of external devices. Furthermore, although specific terms may be employed herein, they are used in a generic and descriptive sense only and not for purposes of limitation. Therefore, a person skilled in the art would recognize numerous variations to the described embodiments that would still fall within the scope of the appended claims. Furthermore, although individual features may be included in different claims (or embodiments), these may possibly advantageously be combined, and the inclusion of different claims (or embodiments) does not imply that a combination of features is not feasible and/or advantageous. In addition, singular references do not exclude a plurality. Finally, reference signs in the claims are provided merely as a clarifying example and should not be construed as limiting the scope of the claims in any way.

## Claims

1. A breakout assembly board (200) for a configurable controller cabinet for management of a building
a plurality of connection blocks (215) configured to provide a connection to one or more functions (13, 15) of a building (10);
a plurality of port connectors (213) configured to be connected to a plurality of ports (125) of a controller device (120); and
routing adapted to connect the plurality of port connectors (213) to one or more of the connection blocks (215) such that the controller device (120) is operatively connected to the one or more functions (13, 15) of the building.

2. The breakout assembly board (200) of claim 1, wherein a number of connection blocks (215) of the breakout assembly board (200) is greater than a number of ports (125) of the controller device (120).

3. The breakout assembly board (200) of claim 1 or 2, comprising a plurality of function blocks (210), wherein each function block (210) comprises two or more connection blocks (215), preferably wherein the breakout assembly board (200) is configured to connect at least one respective connection block (215) of two or more function blocks (210) to a common reference of the controller device (120).

4. The breakout assembly board (200) of claim 3, wherein the breakout assembly board (200) is configured to connect at least one respective connection block (215) of two or more function blocks (210) to a power supply voltage of the controller device (120).

5. The breakout assembly board (200) of claim 3 or 4, wherein the function blocks (210) are one or more of an input function block (210), an output function block (210), a power function block (210), a sensor function block (210) and/or a general purpose input/output, GPIO, function block (210).

6. The breakout assembly board (200) of any one of claims 1 to 5, comprising at least one relay (240) arranged in series between two connection blocks (215) and the breakout assembly board (200) is configured such that the at least one relay (240) is controllable from one or more ports (125) of the controller device (120).

7. A configurable controller cabinet (100) for management of a building (10) having one or more functions (13, 15), the controller cabinet (100) comprising:
the breakout assembly board (200) of any of claims 1 to 6; and
a controller device (120) provided with a plurality of ports (125), the controller device (120) configured to control the one or more functions (13, 15) of the building (10).

8. The controller cabinet (100) of claim 7, further comprising a mounting rail (120), wherein the controller device (120) is mounted on the mounting rail (110) and the mounting rail (110) is arranged between the controller device (120) and the breakout assembly board (200), preferably the mounting rail (110) is a DIN rail.

9. The controller cabinet (100) of claim 7 or 8, further comprising at least one cable duct (130) arranged at one or more inner side surfaces of the controller cabinet (100) and configured receive exterior cables (20) from an outside of the controller cabinet (100), wherein the cable duct (130) is provided with a plurality of slots (135) facing an inside of the controller cabinet (100) for routing of interior cables (170) comprised in the exterior cables (20), from the cable duct (130) to connection blocks (215) of the breakout assembly board (200).

10. The controller cabinet (100) of any one of claims 7 to 9, wherein each of the plurality of ports (125) of the controller device (120) is connected to one port connector (213).

11. The controller cabinet (100) of any one of claims 7 to 10, wherein the breakout assembly board (200) comprises at least one fuse (230) arranged in series between one or more connection block (215) and one or more power supply ports (125) of the controller device (120).

12. The controller cabinet (100) of any one of claims 7 to 11, further comprising a power supply device (140) electrically connected to two or more connection blocks (215) of the breakout assembly board (200).

13. The controller cabinet (100) of any one of claims 7 to 12, wherein the breakout assembly board (200) is attached to an inner surface of the controller cabinet (100).

14. A controller cabinet system (300) comprising a controller cabinet (100) of any one of claims 7 to 13 and a plurality of interior cable markers (175), wherein each interior cable marker (170) is associated with one specific connection block (215) of the breakout assembly board (200) and being configured to be attached to an interior cable (170) inside the controller cabinet (100), preferably wherein the breakout assembly board (200) comprises a plurality of function blocks (210) and the controller cabinet system (300) further comprises a plurality of exterior cable markers (25), wherein each exterior cable marker (25) is associated with one specific function block (210) of the breakout assembly board (200) and being configured to be attached to an exterior cable (20) outside the controller cabinet (100).

15. The controller cabinet system (300) of claim 14, further comprising an IO-map template (310) for indicating connections between exterior cables (20) and connection blocks (215) of the breakout assembly board (200).

## Patentansprüche

1. Breakout-Montageplatte (200) für einen konfigurierbaren Steuerschrank zur Verwaltung eines Gebäudes, umfassend
eine Vielzahl von Anschlussklemmen (215), die dafür ausgelegt sind, eine Verbindung zu einer oder mehreren Funktionen (13, 15) eines Gebäudes (10) bereitzustellen;
eine Vielzahl von Port-Anschlüssen (213), die dafür ausgelegt sind, mit einer Vielzahl von Ports (125) eines Steuergeräts (120) verbunden zu werden; und
eine Leiterführung, die dazu ausgelegt ist, die Vielzahl von Port- Anschlüssen (213) mit einer oder mehreren der Anschlussklemmen (215) zu verbinden, sodass das Steuergerät (120) betriebsmäßig mit der einen oder den mehreren Funktionen (13, 15) des Gebäudes verbunden ist.

2. Breakout-Montageplatte (200) nach Anspruch 1, wobei eine Anzahl von Anschlussklemmen (215) der Breakout-Montageplatte (200) größer ist als eine Anzahl von Ports (125) des Steuergeräts (120).

3. Breakout-Montageplatte (200) nach Anspruch 1 oder 2, umfassend eine Vielzahl von Funktionsblöcken (210), wobei jeder Funktionsblock (210) zwei oder mehr Anschlussklemmen (215) umfasst, wobei bevorzugt die Breakout-Montageplatte (200) dafür ausgelegt ist, jeweils zumindest eine Anschlussklemme (215) von zwei oder mehr Funktionsblöcken (210) mit einem gemeinsamen Referenzpotenzial des Steuergeräts (120) zu verbinden.

4. Breakout-Montageplatte (200) nach Anspruch 3, wobei die Breakout-Montageplatte (200) dafür ausgelegt ist, jeweils zumindest eine Anschlussklemme (215) von zwei oder mehr Funktionsblöcken (210) mit einer Versorgungsspannung des Steuergeräts (120) zu verbinden.

5. Breakout-Montageplatte (200) nach Anspruch 3 oder 4, wobei die Funktionsblöcke (210) ein Eingangs-Funktionsblock (210) und/oder ein Ausgangs-Funktionsblock (210) und/oder ein Leistungs-Funktionsblock (210) und/oder ein Sensor-Funktionsblock (210) und/oder ein Allgemeiner-Zweck-Eingangs/Ausgangs-Funktionsblock, GPIO, (210) sind.

6. Breakout-Montageplatte (200) nach einem der Ansprüche 1 bis 5, umfassend zumindest ein Relais (240), das in Reihe zwischen zwei Anschlussklemmen (215) angeordnet ist, wobei die Breakout-Montageplatte (200) derart ausgelegt ist, dass das zumindest eine Relais (240) über einen oder mehrere Ports (125) des Steuergeräts (120) steuerbar ist.

7. Konfigurierbarer Steuerschrank (100) zur Verwaltung eines Gebäudes (10) mit einer oder mehreren Funktionen (13, 15), wobei der Steuerschrank (100) umfasst:
die Breakout-Montageplatte (200) nach einem der Ansprüche 1 bis 6; und
ein Steuergerät (120) mit einer Vielzahl von Ports (125), wobei das Steuergerät (120) dafür ausgelegt ist, die eine oder die mehreren Funktionen (13, 15) des Gebäudes (10) zu steuern.

8. Steuerschrank (100) nach Anspruch 7, ferner umfassend eine Montageschiene (110), wobei das Steuergerät (120) auf der Montageschiene (110) montiert ist und die Montageschiene (110) zwischen dem Steuergerät (120) und der Breakout-Montageplatte (200) angeordnet ist, wobei bevorzugt die Montageschiene (110) eine DIN-Schiene ist.

9. Steuerschrank (100) nach Anspruch 7 oder 8, ferner umfassend zumindest einen Kabelkanal (130), der an einer oder mehreren inneren Seitenflächen des Steuerschranks (100) angeordnet ist und dafür ausgelegt ist, Außenkabel (20) von außerhalb des Steuerschranks (100) aufzunehmen, wobei der Kabelkanal (130) mit einer Vielzahl von Schlitzen (135) versehen ist, die zur Innenseite des Steuerschranks (100) weisen, zum Führen von Innenkabeln (170), die Bestandteil der Außenkabel (20) sind, von dem Kabelkanal (130) zu den Anschlussklemmen (215) der Breakout-Montageplatte (200).

10. Steuerschrank (100) nach einem der Ansprüche 7 bis 9, wobei jeder der Vielzahl von Ports (125) des Steuergeräts (120) mit genau einem Port-Anschluss (213) verbunden ist.

11. Steuerschrank (100) nach einem der Ansprüche 7 bis 10, wobei die Breakout-Montageplatte (200) zumindest eine Sicherung (230) umfasst, die in Reihe zwischen einer oder mehreren Anschlussklemmen (215) und einem oder mehreren Versorgungsports (125) des Steuergeräts (120) angeordnet ist.

12. Steuerschrank (100) nach einem der Ansprüche 7 bis 11, ferner umfassend ein Stromversorgungsgerät (140), das elektrisch mit zwei oder mehr Anschlussklemmen (215) der Breakout-Montageplatte (200) verbunden ist.

13. Steuerschrank (100) nach einem der Ansprüche 7 bis 12, wobei die Breakout-Montageplatte (200) an einer inneren Oberfläche des Steuerschranks (100) befestigt ist.

14. Steuerschrank-System (300), umfassend einen Steuerschrank (100) nach einem der Ansprüche 7 bis 13 sowie eine Vielzahl von Innenkabelmarkierungen (175), wobei jede Innenkabelmarkierung (175) einer spezifischen Anschlussklemme (215) der Breakout-Montageplatte (200) zugeordnet ist und dafür ausgelegt ist, an einem Innenkabel (170) innerhalb des Steuerschranks (100) befestigt zu werden, bevorzugt wobei die Breakout-Montageplatte (200) eine Vielzahl von Funktionsblöcken (210) umfasst und das Steuerschrank-System (300) ferner eine Vielzahl von Außenkabelmarkierungen (25) umfasst, wobei jede Außenkabelmarkierung (25) einem spezifischen Funktionsblock (210) der Breakout-Montageplatte (200) zugeordnet ist und dafür ausgelegt ist, an einem Außenkabel (20) außerhalb des Steuerschranks (100) befestigt zu werden.

15. Steuerschrank-System (300) nach Anspruch 14, ferner umfassend eine IO-Plan-Vorlage (310) zur Anzeige von Verbindungen zwischen Außenkabeln (20) und Anschlussklemmen (215) der Breakout-Montageplatte (200).

## Revendications

1. Carte d'ensemble de branchement (200) pour une armoire de commande configurable pour la gestion d'un bâtiment comprenant :
une pluralité de blocs de connexion (215) configurés pour fournir une connexion à une ou plusieurs fonctions (13, 15) d'un bâtiment (10) ;
une pluralité de connecteurs de port (213) configurés pour être connectés à une pluralité de ports (125) d'un dispositif de commande (120) ; et
un routage adapté pour connecter la pluralité de connecteurs de port (213) à un ou plusieurs des blocs de connexion (215) de sorte que le dispositif de commande (120) soit connecté de manière opérationnelle aux une ou plusieurs fonctions (13, 15) du bâtiment.

2. Carte d'ensemble de branchement (200) selon la revendication 1, dans laquelle un nombre de blocs de connexion (215) de la carte d'ensemble de branchement (200) est supérieur à un nombre de ports (125) du dispositif de commande (120).

3. Carte d'ensemble de branchement (200) selon la revendication 1 ou 2, comprenant une pluralité de blocs de fonction (210), dans laquelle chaque bloc de fonction (210) comprend deux blocs de connexion (215) ou plus, de préférence dans laquelle la carte d'ensemble de branchement (200) est configurée pour connecter au moins un bloc de connexion (215) respectif de deux blocs de fonction (210) ou plus à une référence commune du dispositif de commande (120).

4. Carte d'ensemble de branchement (200) selon la revendication 3, dans laquelle la carte d'ensemble de branchement (200) est configurée pour connecter au moins un bloc de connexion (215) respectif de deux blocs de fonction (210) ou plus à une tension d'alimentation du dispositif de commande (120).

5. Carte d'ensemble de branchement (200) selon la revendication 3 ou 4, dans laquelle les blocs de fonction (210) sont un ou plusieurs blocs parmi un bloc de fonction (210) d'entrée, un bloc de fonction (210) de sortie, un bloc de fonction (210) d'alimentation, un bloc de fonction (210) de capteur et/ou un bloc de fonction (210) d'entrée/sortie à usage général, GPIO.

6. Carte d'ensemble de branchement (200) selon l'une quelconque des revendications 1 à 5, comprenant au moins un relais (240) agencé en série entre deux blocs de connexion (215) et la carte d'ensemble de branchement (200) est configurée de sorte que l'au moins un relais (240) soit commandable à partir d'un ou de plusieurs ports (125) du dispositif de commande (120).

7. Armoire de commande configurable (100) pour la gestion d'un bâtiment (10) présentant une ou plusieurs fonctions (13, 15), l'armoire de commande (100) comprenant :
la carte d'ensemble de branchement (200) selon l'une quelconque des revendications 1 à 6 ; et
un dispositif de commande (120) doté d'une pluralité de ports (125), le dispositif de commande (120) étant configuré pour commander les une ou plusieurs fonctions (13, 15) du bâtiment (10).

8. Armoire de commande (100) selon la revendication 7, comprenant en outre un rail de montage (120), dans laquelle le dispositif de commande (120) est monté sur le rail de montage (110) et le rail de montage (110) est agencé entre le dispositif de commande (120) et la carte d'ensemble de branchement (200), de préférence le rail de montage (110) est un rail DIN.

9. Armoire de commande (100) selon la revendication 7 ou 8, comprenant en outre au moins un conduit de câbles (130) agencé au niveau d'une ou de plusieurs surfaces latérales internes de l'armoire de commande (100) et configuré pour recevoir des câbles extérieurs (20) à partir d'un extérieur de l'armoire de commande (100), dans laquelle le conduit de câbles (130) est doté d'une pluralité de fentes (135) faisant face à un intérieur de l'armoire de commande (100) pour l'acheminement de câbles intérieurs (170) compris dans les câbles extérieurs (20), du conduit de câbles (130) aux blocs de connexion (215) de la carte d'ensemble de branchement (200).

10. Armoire de commande (100) selon l'une quelconque des revendications 7 à 9, dans laquelle chacun de la pluralité de ports (125) du dispositif de commande (120) est connecté à un connecteur de port (213).

11. Armoire de commande (100) selon l'une quelconque des revendications 7 à 10, dans laquelle la carte d'ensemble de branchement (200) comprend au moins un fusible (230) agencé en série entre un ou plusieurs blocs de connexion (215) et un ou plusieurs ports d'alimentation électrique (125) du dispositif de commande (120).

12. Armoire de commande (100) selon l'une quelconque des revendications 7 à 11, comprenant en outre un dispositif d'alimentation électrique (140) connecté électriquement à deux blocs de connexion (215) ou plus de la carte d'ensemble de branchement (200).

13. Armoire de commande (100) selon l'une quelconque des revendications 7 à 12, dans laquelle la carte d'ensemble de branchement (200) est fixée à une surface interne de l'armoire de commande (100).

14. Système d'armoire de commande (300) comprenant une armoire de commande (100) selon l'une quelconque des revendications 7 à 13 et une pluralité de marqueurs de câble intérieurs (175), dans lequel chaque marqueur de câble intérieur (170) est associé à un bloc de connexion spécifique (215) de la carte d'ensemble de branchement (200) et configuré pour être fixé à un câble intérieur (170) à l'intérieur de l'armoire de commande (100), de préférence dans lequel la carte d'ensemble de branchement (200) comprend une pluralité de blocs de fonction (210) et le système d'armoire de commande (300) comprend en outre une pluralité de marqueurs de câble extérieurs (25), dans lequel chaque marqueur de câble extérieur (25) est associé à un bloc de fonction (210) spécifique de la carte d'ensemble de branchement (200) et configuré pour être fixé à un câble extérieur (20) à l'extérieur de l'armoire de commande (100).

15. Système d'armoire de commande (300) selon la revendication 14, comprenant en outre un modèle de carte d'E/S (310) destiné à indiquer des connexions entre des câbles extérieurs (20) et des blocs de connexion (215) de la carte d'ensemble de branchement (200).
